# EUROPEAN PATENT APPLICATION

(11) **EP 1 852 526 A1**
(43) Date of publication of application: **07.11.2007**
(21) Application number: 06830895.6
(22) Date of filing: 26.01.2006
(51) Int. Cl.: C30B 7/00, C30B 29/58

(54) **METHOD AND SET OF TOOLS FOR CHECKING THE CRYSTALLISATION CONDITIONS OF BIOLOGICAL MACROMOLECULES**

(30) Priority: 28.01.2005 ES 200500171
(71) Applicant: Consejo Superior de Investigaciones Cientificas (CSIC), 28006 Madrid (ES)
(72) Inventor: GARCIA RUIZ, Juan Manuel, Insto. Andaluz de Ciencias de la Tierra, E-18002 Granada (ES); GONZALEZ RAMIREZ, Luis Antonio, Insto. Andaluz de Ciencias de la Tierra, E-18002 Granada (ES)
(74) Representative: Ungria Lopez, Javier
(86) International application number: PCT/ES2006/070004
(87) International publication number: WO 2007/036588

(57) **Abstract**

Abstract: The invention relates to a method and set of tools for checking and ascertaining the crystallisation conditions of biological macromolecules using the counter-diffusion technique which employs precipitating agents, additives and buffers. The concentration of the precipitating agent(s) in the medium (solution or gel) is greater than those currently used with other available checking techniques, such as batch, microbatch or vapour phase diffusion techniques, such that, as a result of the diffusion along the length of the capillary containing the biological macromolecule, a large number of concentrations of the precipitating agent(s) used in one experiment are checked. The set of tools or kit contains the necessary elements for performing said method.

## Description

### OBJECT OF THE INVENTION

The object of the present invention relates to a method for checking and ascertaining the crystallisation conditions of biological macromolecules using the counter-diffusion technique which employs precipitating agents, additives and buffers.

Likewise forming an object of the present invention is a set of tools, commonly known as a kit, for checking crystallisation conditions of biological macromolecules.

### STATE OF THE ART

It is impossible nowadays to predict the crystallisation conditions of biological macromolecules (hereinafter, MB, referring both to proteins and to nucleic acids, carbohydrates, viruses or any of their complexes or combinations). Therefore, the only way to find the chemical conditions under which a MB crystallises is to conduct an experimental check by trial and error of the variables that usually affect the solubility of MBs. Such variables are temperature, pH, and the change of solubility which what are known as precipitating agents (PAs) have on the solutions of MBs. These checks are usually conducted by means of certain "kits" or set of solutions (whether home-produced or commercial) which have historically or statistically shown themselves to be the most successful when it comes to crystallising the MBs {[1] Jancarik and Kim (1991) Sparse matrix sampling: a screening method for crystallisation of proteins. J. Appl. Crystal. 24: 409; [2] Cudney et al. (1994) Screening and optimisation strategies for macromolecular crystal growth. Acta Cryst. D 50: 414; [3] Gilliland et al. (2002) The Biological Macromolecule Crystallisation database: crystallisation procedures and strategies. Acta Cryst. D58 (6-1): 916; [4] Kimber et al. Data mining crystallisation databases: Knowledge-based approaches to optimise protein crystal screens. Proteins 51: 562. 1-4}.

These PAs or additive solutions are directly mixed with the MB solutions (batch or microbatch technique) or they are balanced by evaporation with the MB solution (vapour phase diffusion technique). In those techniques, each experiment checks the effect of a precipitating agent or an additive at a certain concentration (batch or microbatch technique) or at a small range of concentrations (vapour phase diffusion technique).

The object of the present invention is a method for checking the crystallisation conditions of MB using the counter-diffusion technique. The counter-diffusion technique has been used in recent years as a crystallisation method for biological macromolecules {[5] J.M. Garcia-Ruiz, Counterdiffusion Methods for Macromolecular Crystallisation. Methods in Enzymology, Vol. 368 (2003) 130-154; [6] D. Maes, L.A. Gonzalez-Ramirez, J. Lopez-Jaramillo, B. Yu, H. De Bondt; I. Zegers, E. Afonina, J.M. Garcia-Ruiz and S. Gulnik, Structural study of the type II 3-dehydroquinate dehydratase from Actinobacillus pleuropneumoniae. Acta Crystallographica D 60 (2004) 463.-471; [7] J.A. Gavira, D. Toh, F.J. Lopez-Jaramillo, J.M. Garcia-Ruiz and J.D. Ng. Ab Initio crystallographic structure determination of insulin from protein to electron density without crystal handling. Acta Crystallographica D 58 (2002) 1147-1154}. There exist various patents for the design of devices for growing MB crystals by counter-diffusion. Nevertheless, the use of the technique for the checking and ascertaining of MB crystallisation conditions has never previously been claimed.

### EXPLANATION OF THE INVENTION

The object of the present invention relates to a method for checking the crystallisation conditions of biological macromolecules using the counter-diffusion technique which includes the following stages.
a) Introduction of a solution, preferably aqueous, buffered or otherwise, of the biological macromolecule to which the check of the crystallisation conditions is being applied, into a device with one-dimensional geometry, preferably a glass or plastic transparent or translucent capillary, and the subsequent closing of one of its ends.
b) Preparation of a medium that contains at least one precipitating agent for biological macromolecules buffered in order to maintain the pH value at between 3 and 10.
c) Introduction of the open end of the device with one-dimensional geometry containing the biological macromolecule into the buffered medium containing at least one precipitating agent.
d) Diffusive transport of the molecules of the buffer and of the precipitating agent(s) via the biological macromolecule solution contained in the device with one-dimensional geometry.

The capillaries which contain the biological macromolecule have an internal diameter of between 1 micron and 1 millimetre, preferably between 25 microns and 300 microns; a length of between 5 and 200 millimetres and are preferably transparent to X rays.

The introduction of the biological macromolecule into the capillary can be done by capillary action or by injection, whether manually or automatically.

The precipitating agents are soluble salts or alcoholic polymers such as polyethyleneglycols of different molecular weight. Two or more precipitating agents are preferably used at the same time in the medium.

The medium containing the precipitating agent or agents also includes detergents, additives such as divalent cations or sugars, or volatile solvents such as methanol, isopropanol or 2-methyl-2,4-pentanodiol.

In the event of the solution containing the biological macromolecule being buffered, the medium containing the precipitating agent(s) must be buffered at a greater concentration than that of the buffer of the solution of the biological macromolecule, in such a way that the pH of the solution with the biological macromolecule can change to the degree that the molecules of the buffer of the medium diffuse with the precipitating agent(s).

Optionally, the medium containing the precipitating agent(s) includes salts of heavy elements, such as mercury salts, for being used as derivatives of biological macromolecules, cryo-protector compounds, for example glycol, for checking crystallographic conditions or substrate molecules or any other molecules which can have the aim of incorporating into, or interacting with, the crystal structure of the biological macromolecule.

The medium containing at least one precipitating agent can be a solution, preferably aqueous, or a thermal gel, preferably agar, or chemical gel, preferably silica or polyacrylamide. In the event of using a non-gellable precipitating agent, for example ammonium sulphate, the solution with that agent is located in such a way that a layer of the thermal or chemical gel is formed on top of the solution with the agent. In all cases, the medium with the precipitating agent is generally contained in a transparent or opaque vessel, made of glass, plastic or any other material that does not chemically interact with said medium in such a way that would impair the effect which the precipitating agents might have on crystallisation. The vessel can optionally include a removable bung that prevents evaporation of the solvents of the medium and permits access to the capillaries.

The concentration of the precipitating agent(s) in the medium (solution or gel) is greater than those normally used with other checking techniques that are available, such as batch, microbatch or vapour phase diffusion, such that, as a result of the diffusion along the capillary containing the biological macromolecule, a large number of concentrations of the precipitating agent(s) used in a single experiment are scanned.

In the event of using a gel as medium for the precipitating agent(s), these can be gelled directly when the gel is produced or diffused in the gel after it has been prepared in accordance with the interaction and stability of the different precipitating agents with the different types of gel.

The introduction of the capillaries into the medium containing the precipitating agent(s) can be done manually or automatically, by means of some robotic mechanism.

Likewise constituting an object of the present invention is a set of tools (kit) for checking the crystallisation conditions of biological macromolecules using the counter-diffusion technique which includes the following elements:
- between 1 and 100, preferably between 1 and 10, counter-diffusion crystallisation devices, said devices being filled with a medium containing at least one precipitating agent.
- between 2 and 500, preferably between 4 and 40, capillaries of diameter between 1 micron and 1 mm, preferably between 25 microns and 300 microns; with a length between 5 and 200 millimetres and preferably transparent to X rays.
- means for sealing said capillary tubes, preferably plasticine.

The medium containing at least one precipitating agent is a solution, preferably aqueous, or a thermal gel, preferably agar, or chemical gel, preferably silica or polyacrylamide. In the event of using a non-gellable precipitating agent, an aqueous solution with said precipitating agent is located beneath a layer of the thermal or chemical gel.

### BRIEF DESCRIPTION OF THE FIGURES

Figure 1. Typical crystallisation pattern in counter-diffusion.
Figure 2. Crystallisation of lysozyme in counter-diffusion in capillaries showing the effect of the capillary diameter (from the top down, 0.2, 0.3 and 0.5 mm).

### MODE OF EMBODIMENT OF THE INVENTION

Example of embodiment of the method

As an example of the advantages of the method of the present invention, a case is presented in which gels are used of two precipitating agents of different molecular weight, as such sodium chloride and a polyethyleneglycol (PEG) of molecular weight 2000 daltons, buffered with a sodium acetate buffer to pH 4.5 100 mM. The steps for carrying out the inventive method are:
1) A solution of PEG 2000 at 50% p/v is prepared in a 100 mM acetate buffer.
2) The necessary quantity of sodium chloride is added so that the concentration of sodium chloride in the solution of step 1 is 20%.
3) To the solution prepared in step 2 is added a quantity of agar necessary so that the agar concentration is 0.5% p/v.
4) The solution of step 3 is raised to a temperature above the melting point of agar while being stirred vigorously.
5) When the solution of step 4 is transparent, it is poured into a vessel and left to cool to below the gelling temperature so that the gel is formed.
6) A glass capillary is taken of internal diameter 50 microns and length 400 millimetres.
7) It is filled with a solution of protein dissolved in water or in a buffer with a strength of 50 mM.
8) One of the ends of the capillary is closed, for example with wax.
9) The other end of the capillary is dipped in the gel.
10) The vessel containing the gel and the capillary is closed.

The diffusivity of a molecule depends on its molecular weight, as established by the Stokes-Einstein law. Therefore the acetate buffer and the salt will start to rise up the capillary and effect of the concentration of sodium chloride will be checked along the entire capillary containing the protein solution. Molecules of PEG2000 of much larger size will diffuse more slowly and so the effect of the concentration of PEG will be checked after this has been done for the salt solution. These two "successive waves of concentration" of different molecules mean that in a single experiment a check can be made of not just the effect of one precipitating agent on a concentration (which is what is done by the techniques available now) but also the effect of different concentrations of two or more precipitating agents of different molecular weight.

### Example of a set of tools (kit) for carrying out the inventive method

The use of the method for checking the crystallisation conditions can be carried out by means of a set of tools or "kit" comprising the following elements:
1) 4 devices for growth of crystals in counter-diffusion according to Spanish patents 2172363 and 2164032 known as "Granada Crystallisation Box" or "GCB", both of them being registered trademarks. Said devices will previously have been filled with 3 ml of agar gel and precipitating agents chosen depending on the macromolecule whose crystallisation conditions are going to be checked.
2) 24 capillary tubes of different diameters (0.1 mm, 0.2 mm and 0.3 mm), eight for each size.
3) Plasticine for sealing the capillary tubes.

In order to carry out the crystallisation experiments for teaching purposes, the proteins and precipitating agents shown in table 1 will preferably be used. This table also states the concentration ranges and composition of the buffers.

| **Table 1** | | | | |
|---|---|---|---|---|
| *Protein to crystallise* | *Recommended protein concentrations* | *Precipitating agent* | *pH* | *Buffer* |
| Lysozyme | 30 mg/ml and 50 mg/ml | sodium chloride | 4.5 | 50 mM sodium acetate |
| Glucose isomerase | 30 mg/ml and 50 mg/ml | PEG 400 + MgCl₂ | 7.0 | 100 mM tris-HCl |
| Taumatine | 30 mg/ml and 50 mg/ml | Na/K tartarate | 6.5 | 100 mM sodium phosphate |
| Insulin | 30 mg/ml and 50 mg/ml | PEG 4K + Na/K tartarate | 10.5 | Na₂HPO₄ |

In order to conduct the experiment, one proceeds according to the following steps:
a) select a GCB pre-filled with the gel and the precipitating agent from the set of tools (kit) and the corresponding protein solution that is going to be tested in it.
b) prepare the protein solution at the concentrations recommended in table 1, unbuffered or buffered with the same buffer as the precipitating agent.
c) take a capillary of diameter 0,1 mm and introduce one of its ends into the protein solution.
d) fill the capillary tube by capillary action. The rate of ascent of the protein solution will depend on its viscosity (therefore its concentration) and on gravity (therefore on the inclination of the capillary tube), being slower when the capillary tube is in the vertical position.
e) seal the free end of the capillary tube with plasticine.
f) dip the capillary in the gel containing the precipitating agent and which is now in the selected GCB.
g) repeat the steps using different concentrations of protein and varying the diameter of the capillary tube.

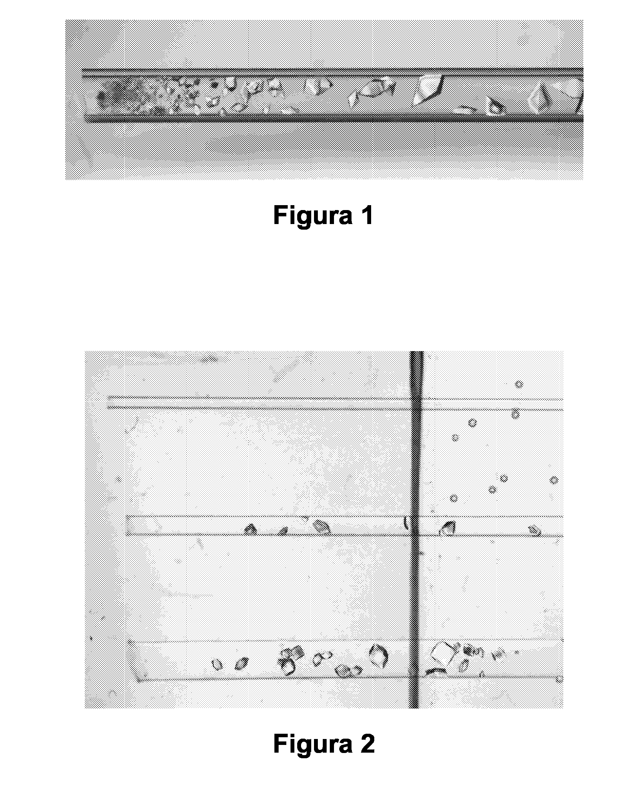

The counter-diffusion technique provokes a sudden nucleation event at the entrance to the capillary where the supersaturation is very high. Afterwards, the system is displaced towards equilibrium, to lower degrees of supersaturation. A crystallisation pattern appears along the capillary tube which evolves from an amorphous precipitate of crystals of low quality and small size towards crystals of higher quality and larger size (see figure 1). When capillary tubes of larger diameter are used, larger amounts of protein solution are employed. It can be seen (figure 2) that the larger the diameter of the capillary tube used, the quicker the precipitating agent penetrates into the capillary tube and the earlier the crystallisation takes place.

## Claims

1. Method for checking the crystallisation conditions of biological macromolecules using the counter-diffusion technique, **characterised in that** it comprises the following stages:
a) the introduction of a solution, preferably aqueous, buffered or otherwise, of the biological macromolecule to which the check of the crystallisation conditions is being applied, into a device with one-dimensional geometry, preferably a glass or plastic transparent or translucent capillary, and the subsequent closing of one of its ends;
b) the preparation of a medium that contains at least one precipitating agent for biological macromolecules buffered in order to maintain the pH value at between 3 and 10;
c) the introduction of the open end of the device with one-dimensional geometry containing the biological macromolecule into the buffered medium containing at least one precipitating agent;
d) and the diffusive transport of the molecules of the buffer and of the precipitating agent(s) via the biological macromolecule solution contained in the device with one-dimensional geometry.

2. Method for checking the crystallisation conditions of biological macromolecules according to claim 1, **characterised in that** the capillary containing the biological macromolecule has an internal diameter of between 1 micron and 1 millimetre, preferably between 25 microns and 300 microns; a length of between 5 and 200 millimetres and **in that** it is preferably transparent to X rays.

3. Method for checking the crystallisation conditions of biological macromolecules according to claims 1-2, **characterised in that** the precipitating agents are soluble salts or alcoholic polymers such as polyethyleneglycols of different molecular weight.

4. Method for checking the crystallisation conditions of biological macromolecules according to claims 1-3, **characterised in that** the medium containing at least one precipitating agent also includes detergents, additives such as divalent cations or sugars, or volatile solvents such as ethanol, methanol, isopropanol or 2-methyl-2,4-pentanodiol.

5. Method for checking the crystallisation conditions of biological macromolecules according to claims 1-4, **characterised in that** in the event of the solution containing the biological macromolecule being buffered, the medium containing at least one precipitating agent must be buffered at a greater concentration than that of the buffer of the solution of the biological macromolecule, in such a way that the pH of the solution with the biological macromolecule can change to the degree that the molecules of the buffer of the medium diffuse with the precipitating agent or agents.

6. Method for checking the crystallisation conditions of biological macromolecules according to claims 1-5, **characterised in that** the medium containing at least one precipitating agent optionally includes salts of heavy elements for being used as derivatives of biological macromolecules.

7. Method for checking the crystallisation conditions of biological macromolecules according to claims 1-6, **characterised in that** the medium containing at least one precipitating agent optionally includes cryo-protector compounds for checking crystallographic conditions.

8. Method for checking the crystallisation conditions of biological macromolecules according to claims 1-7, **characterised in that** the medium containing at least one precipitating agent includes substrate molecules or any other molecule which can have the aim of incorporating into, or interacting with, the crystal structure of the biological macromolecule.

9. Method for checking the crystallisation conditions of biological macromolecules according to claims 1-8, **characterised in that** the medium containing at least one precipitating agent is a solution, preferably aqueous.

10. Method for checking the crystallisation conditions of biological macromolecules according to claims 1-8, **characterised in that** the medium containing at least one precipitating agent is a thermal gel, preferably agar, or chemical gel, preferably silica or polyacrylamide.

11. Method for checking the crystallisation conditions of biological macromolecules according to claims 1-8, **characterised in that** when the precipitating agent is non-gellable the aqueous solution with the precipitating agent remains below a layer of thermal or chemical gel.

12. Method for checking the crystallisation conditions of biological macromolecules according to claims 1 to 11, **characterised in that** the medium containing at least one precipitating agent is contained in a transparent or opaque vessel, made of glass, plastic or any other material that does not chemically interact with said medium and which can optionally include a removable bung that prevents evaporation of the solvents of the medium.

13. Method for checking the crystallisation conditions of biological macromolecules according to claims 1-12, **characterised in that** the medium preferably contains two or more precipitating agents.

14. Set of tools (kit) for checking the crystallisation conditions of biological macromolecules using the counter-diffusion technique, **characterised in that** it includes the following elements:
- between 1 and 100, preferably between 1 and 10, counter-diffusion crystallisation devices, said devices being filled with a medium containing at least one precipitating agent,
- between 2 and 500, preferably between 4 and 40, capillaries of diameter between 1 micron and 1 mm, preferably between 25 microns and 300 microns; with a length between 5 and 200 millimetres and preferably transparent to X rays,
- means for sealing said capillary tubes, preferably plasticine.

15. Set of tools (kit) for checking the crystallisation conditions of biological macromolecules according to claim 14, **characterised in that** the medium containing at least one precipitating agent is a solution, preferably aqueous.

16. Set of tools (kit) for checking the crystallisation conditions of biological macromolecules according to claim 14, **characterised in that** the medium containing at least one precipitating agent is a thermal gel, preferably agar, or chemical gel, preferably silica or polyacrylamide.

17. Set of tools (kit) for checking the crystallisation conditions of biological macromolecules according to claim 14, **characterised in that** the medium containing at least one precipitating agent is an aqueous solution with the precipitating agent located beneath a layer of the thermal or chemical gel.
